**Europäisches Patentamt**

**European Patent Office**

**Office européen des brevets**

(19)

(11) Publication number: **0 145 403**
**A2**

(12) # EUROPEAN PATENT APPLICATION

(21) Application number: **84308219.9**

(22) Date of filing: **27.11.84**

(51) Int. Cl.⁴: **H 01 L 29/04, H 01 L 31/02, H 01 L 21/205, H 01 L 31/18**

(30) Priority: **07.12.83 US 558959**

(43) Date of publication of application: **19.06.85 Bulletin 85/25**

(84) Designated Contracting States: **BE DE FR GB IT NL**

(71) Applicant: **ENERGY CONVERSION DEVICES, INC., 1675 West Maple Road, Troy Michigan 48084 (US)**

(72) Inventor: **Fritzsche, Hellmut, 5801 S. Blackstone, Chicago Illinois 60637 (US)**
Inventor: **Ovshinsky, Stanford R., 2700 Squirrel Road, Bloomfield Hills Michigan 48013 (US)**
Inventor: **Adler, David, 10 Nickerson Road, Lexington Massachusetts 02173 (US)**

(74) Representative: **Boon, Graham Anthony et al, Elkington and Fife High Holborn House 52/54 High Holborn, London, WC1V 6SH (GB)**

(54) Semiconducting multilayered structures and systems and methods for synthesizing the structures and devices incorporating the structures.

(57) A new class of synthesized semiconducting multiple layer materials, structures, and devices and apparatus and methods for synthesizing the structures. At least one layer (138a) of the multiple layer structure (138) is a disordered semiconductor material. Multiple layer structures can form one or more regions of improved photoresponsive and photovoltaic single and tandem cells, thin film transistors and thermoelectric devices. The multiple layer structures provide a means of electronically doping semiconductor device structures without adding substitutional dopant impurities.

This invention relates to a new class of synthetic semiconductors, semiconducting structures, devices incorporating those structures and methods of synthesizing the structures and devices. The invention overcomes the limitations of known semiconductor device structures and deposition apparatus by providing for the deposition of multiple thin layers of amorphous materials to form regions having preselected characteristics. The novel device structures include at least one region having a plurality of layers of disordered semiconducting material. By varying the composition of the multiple layers, material characteristics tailored for desired applications may be attained. Amorphous semiconducting materials, which are by definition non-periodic, may be formed according to the invention into a periodic arrangement of layers that together form a region of a device. By choosing the materials in each of those layers and the arrangement of those layers, devices having selected characteristics may be formed.

The plurality of layers may be formed through various deposition techniques, such as evaporation, sputtering and plasma deposition. The novel structures produced possess new and desired properties, such as greatly extended photoconductivity lifetimes, that have applications in numerous devices. Novel apparatus for producing the incentive material and structures is described herein.

Fig. 1 is a sectional side view of one embodiment of a deposition apparatus according to the invention.

Fig. 2 is a perspective and partial sectional view of one deposition chamber portion of the embodiment of Fig. 1.

Fig. 3 is a perspective view of a viewing port/gas introduction portion of the embodiment of Fig. 1.

Fig. 4 is a perspective and partial sectional view of a substrate deposition portion of the embodiment of Fig. 1.

Fig. 5 is a side sectional view of a second embodiment of a deposition apparatus incorporating the invention.

Fig. 6A is a sectional side view of a portion of a multiple layer structure according to the invention.

Figs. 6B-6F are sectional side views of multiple layer structures according to the invention and schematic forms of the effective modulation of the energy potential of those structures.

Fig. 7 is a sectional side view of a single cell photovoltaic device.

Fig. 8 is a sectional side view of a tandem cell photovoltaic device.

Fig. 9 is a sectional side view of a thin film field effect transistor device.

Fig. 10 is a sectional side view of a photoreceptor.

Each of the novel structures described herein includes at least one disordered semiconducting layer in each multiple layer set. A "multiple layer set" is defined to mean a group including two or more layers. A multiple layer set may be repeated a plurality of times to form the multiple layer structures of the invention. The novel structures can also include a plurality of differing sets of layers each set being formed on another set to form a structure. The term "disordered" is used here to describe all non-crystalline materials, whether amorphous, microcrystalline, polycrystalline or combinations of them. The important characteristic of disordered materials is long range atomic disorder in the material, although there may be instances of short range order. Periodicity of the layers and the layer sets can be utilized to control the disordered materials in the layers.

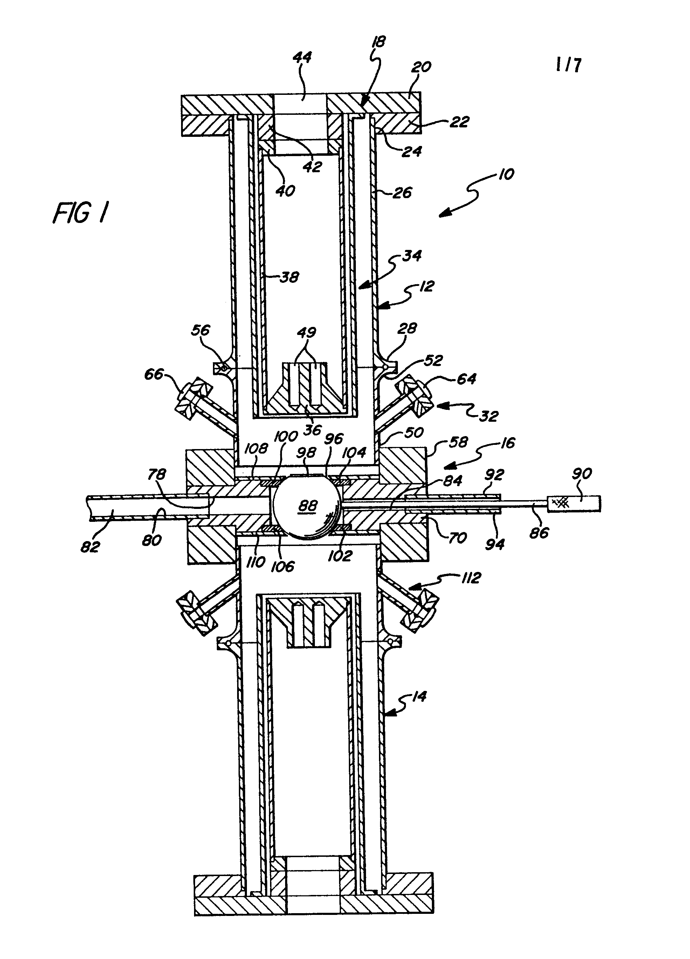

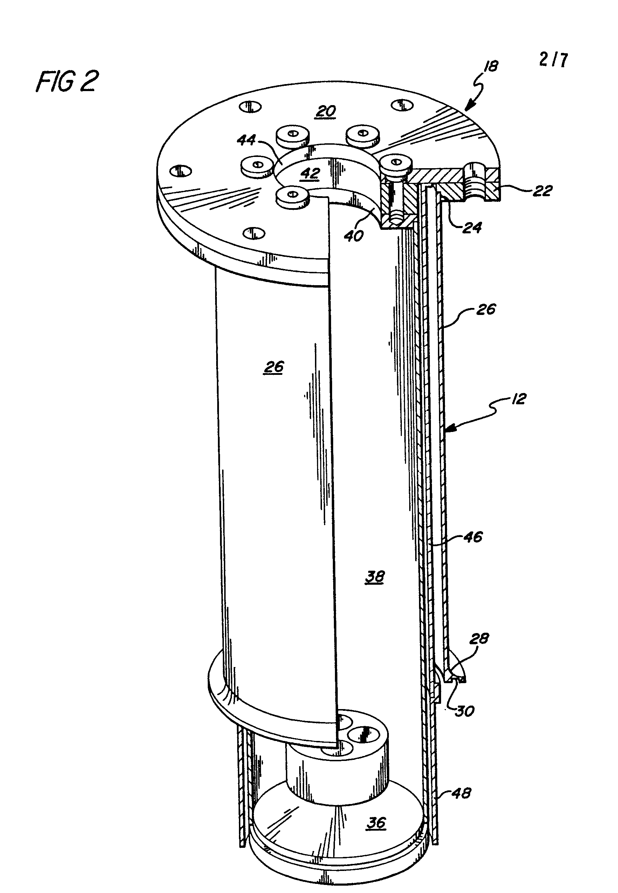

Referring to Fig. 1, there is shown an embodiment of a deposition apparatus 10 which can form the compositionally modulated, that is, multiple layer, semiconducting material structures according to the invention. Apparatus 10 includes a pair of deposition chambers 12 and 14, isolated from one another by a substrate module 16. Deposition chambers 12 and 14 can be of the same or different types, such as sputtering or evaporation chambers, or they can deposit different materials at different times within the same chamber. For convenience, only upper chamber 12 will be described in detail with reference to Figs. 1 and 2 in a plasma deposition configuration.

Chamber 12 has a base plate assembly 18 which includes a base plate 20 upon which the rest of the chamber elements are mounted. A ·retaining ring 22 is mounted to base plate 20 and has an annular recess 24 to which a chamber wall 26 is mounted. The chamber wall includes a sealing flange 28 with an annular groove 30 therein for sealingly engaging with a gas flow and observation module 32.

Chamber 12 includes an electrode assembly 34. Electrode assembly 34 includes an electrode holder 36 which is mounted on an electrode backing cylinder 38. Cylinder 38 is mounted on one or more rings 40 and 42, which are mounted on the base plate 20 and together form an electrode passageway 44 therethrough. Ring 42 can electrically isolate the cylinder 38 from base plate 20. Base plate 20 also preferably has a dark space shield 46 mounted thereto, which shields electrode holder 36 and cylinder 38. Shield 46 can include a separate lower portion 48 shown in (Fig. 2) to facilitate cleaning if desired, or can be an integral unit.

Electrode holder 36 can be heated by heater cartridges (not illustrated) placed in wells 49. When chamber 12 is utilized for sputtering, the targets are mounted on the electrode holder 36. The radio frequency or direct current power for plasma or sputtering deposition is coupled to cylinder 38 through ring 40. Cooling of holder 36 also can be accomplished through passageway 44.

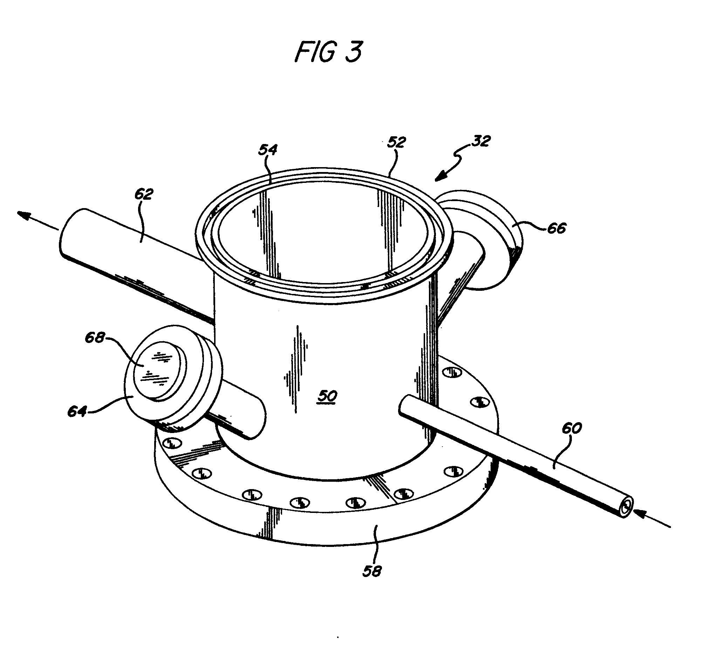

Gas flow and observation module 32 is best illustrated in Fig. 3. The module includes an outer wall 50, having an upper sealing flange 52 containing an annular groove 54. Flange 52 and groove 54 sealingly mate with flange 28 and groove 30 of deposition chamber 12. Preferably, an O-ring 56 or other sealing member is engaged in grooves 30 and 54 to ensure a complete seal between the units, while allowing easy assembly and disassembly of the system 10. Chamber 12 can be replaced by another type of chamber. The embodiment illustrated permits ready access to the deposition region for inserting or removing one or more substrates.

Module 32 has a lower annular sealing ring 58 mounted to substrate module 16. Module 32 includes at least one reaction gas inlet port 60 and at least one exhaust port 62. The module also preferably includes at least one, and preferably two, viewing port assemblies 64 and 66. Assemblies 64 and 66 include a window 68, which can be utilized for optical measurements and monitoring of the deposition process, including thickness measurements of the deposited material layers. The window can be removed and other instruments, such as tuned lasers, or probes can be inserted through the port assemblies 64 and 66 to monitor or assist in the deposition process. The lasers can be tuned to deposit films from a particular reaction gas mixture. Shutters may be used to control admission of reaction gases or mixtures of such gases to the module.

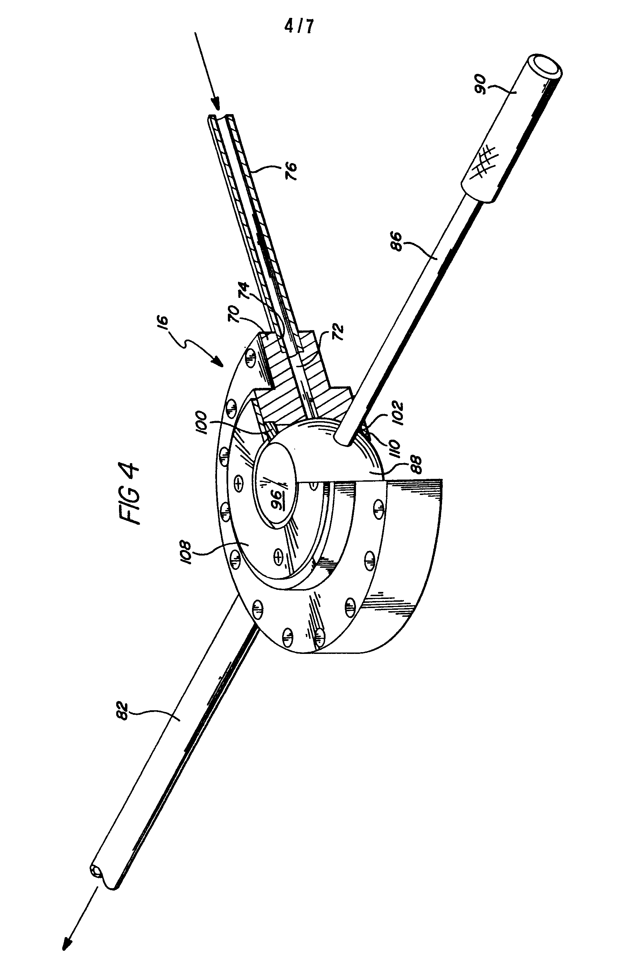

Substrate module 16 is best illustrated in Figs. 1 and 4. Module 16 includes an outer sealing ring 70, to which ring 58 of the module 32 is mounted. Ring 70 includes a passageway 72 having an enlarged portion 74 into which a gas inlet fitting or tubing 76 is mounted. The gas preferably is argon or another inert gas which is utilized as a sweep flow gas in module 16 to prevent any cross contamination between chambers 12 and 14. The gas is exhausted through a passageway 78 which includes an enlarged portion 80 into which an exhaust fitting or tubing 82 is mounted.

Ring 70 also includes a passageway 84 through which is inserted a rod 86 which is mounted in one side of a substrate holder 88 on an axis thereof. Rod 86 is illustrated with a handle 90 on the exposed end thereof which can be used to rotate substrate holder 88 manually. Rod 86, however, typically will be motor driven, in response to a timer, or in response to a thickness monitor mounted in one of port assemblies 64 and 66. Rod 86 is sealingly inserted into passageway 84 through a bushing 92 which is mounted in an enlarged portion 94 of passageway 84.

Substrate holder 88 includes one or more planar portions 96 onto which one or more substrates 98 is mounted. Substrate(s) 98 can be heated by external means or substrate holder 88 can include heaters controlled, for example, through rod 86 (not illustrated). Substrate holder 88 is sealingly, but rotatably mounted in a pair of annular sealing bushings 100 and 102. Bushings 100 and 102 are mounted against mating recesses 104 and 106 formed in ring 70 and are held in place by a pair of retaining rings 108 and 110 which are mounted to ring 70.

Chamber 14, as above mentioned, is illustrated as being identical to chamber 12. However, chamber 14 may alternatively be designed to function in a manner different from that of chamber 12. Chamber 14 also includes a gas flow and an observation module 112, which is substantially identical to module 32, that is mounted to module 16 substantially opposite module 32.

In operation, substrate(s) 98 is mounted on substrate holder 88 which is rotated to dispose the substrate into one of chambers 12 or 14. Material is deposited onto substrate 98 in that chamber for a specified period of time or to a specified layer thickness. Holder 88 is then rotated to position substrate(s) 98 in the opposite chamber to deposit a layer of different material. The multiple layers are formed by rotating the substrate back and forth in a timed sequential pattern between the chambers. Such multiple layers can also be deposited by other types of apparatus, from various reaction gas mixtures and at entirely different power, temperature and pressure conditions different from each other. Thus, the variety of the layered material combinations is substantially unlimited.

More than one type of layer of material can be deposited sequentially on substrate 98 in each chamber by altering or controlling the gas composition fed into the chamber in a desired manner. The sequential layers also can be deposited by utilizing a plurality of controlled sources in each chamber. The deposited layers can be of varied thicknesses, since the layer thicknesses are independently controllable in each chamber, and thicknesses can be varied within the layered composite structure.

As an example, structures can be formed of 200 to 400 alternating layers of pairs of materials, respectively called A and B layers. Multiple layer sets having three repeating layers referred to as A, B and C can be deposited. Still greater numbers of repeating patterns of layers with a group can be prepared, if desired. The substrates can be substantially of any type of material desired, such as metal, glass, quartz, crystalline silicon, etc.

Novel structures can be formed containing alternating layers of insulators, such as oxides or nitrides, and layers of non-oxides, for example, semiconductors, to form a structure such as s-i-s-i-s, etc. The s-i-s-i . . . structures can provide electric charge "doping" by incorporating positive or negative ions or neutral atoms into the insulator layers. The alternating insulator layers, for example formed of $Si_3N_4$ or $SiO_2$ deposited by a plasma, can be doped with atoms or ions during deposition, by sputtering, evaporation or by injection such as through one of ports 64 and 66, to leave a net electric charge on the layer. This method results in "doping" of the adjacent semiconductor layers by an electrical charge transfer mechanism. When the alternating semiconductor layers are thin compared to the electric charge screening length observed in the semiconductor deposited, the charge in the insulating layers alters the electric potential in the semiconducting layer substantially uniformly. As a result, the Fermi level in the semiconductor layer is raised or lowered. In this way, the electrical conduction properties of the structures can be substantially varied without traditional substitutional doping, since one layer acts as a charge donor and one as a charge acceptor. For example, when the overall structure is neutral, negatively charged alternating layers will cause the amorphous or disordered semiconducting layers to be positively charged. The positive charge is essentially evenly distributed through the semiconductor layer. The Fermi level is moved toward the valence band and the semiconducting layers are then p-type or hole conducting. Thus, by selecting the types of layers and their thicknesses, conductivity can be controlled without the addition of dopant impurities. Since no substitutional impurity dopants are introduced into the semiconductor layers, the layers remain relatively defect free and therefore exhibit enhanced photoconductivity, long excess carrier lifetime and diffusion lengths and other superior semiconducting qualities.

Conversely, making the altered layers positively charged causes the semiconducting layers effectively to take on a negative charge. The negative charge is essentially evenly distributed in the semiconducting layers when the layers are thin compared to the screening length of the semiconductor. This change in the potential distribution in the semiconductor causes a shift in the Fermi level towards the conduction band resulting in n-type or electron conduction in the semiconductor layers. Again, this result is accomplished without adding substitutional impurity dopants, rather, the layers are doped by the proximity of the positively charged insulating layers. The semiconductor layers exhibit superior electronic properties as enumerated above.

The invention thus provides essentially defect free electronic n-type and p-type doping of the amorphous semiconductor layers free of defects introduced by substitutional doping. The amorphous layers can be any of a number of amorphous materials, for example, amorphous silicon, germanium, carbon or mixtures thereof, any of which can contain fluorine and/or hydrogen. The amorphous materials can include Se, $As_2Se_3$ and mixtures thereof.

The choice of the positively or negatively charged alternating layer materials and the additives thereto may be determined by the choice of the semiconducting layer material. When the work function, that is the electronegativity of the altered layer is larger than that of the semiconductor layer, generally the altered layer will become negatively charged and the semiconducting material positively charged. The reverse generally occurs when the electronegativity of the work function of the altered layer material is less than that of the semiconducting material.

The charge state of the altered layer also can be changed by controlling the deviation from stoichiometry of the layer, since such deviations produce charged defects in the alternating layer. The charge defects also can be generated by adding or injecting small amounts of additives such as alkali metal ions, rare earth metal ions, transition metal ions and the like or by adding atoms from the higher numbered columns of the periodic chart such as F, Cl or O, S, Se, Te or P, As or Sb.

Examples of insulator layer materials useful in the invention are wide band gap materials such as $SnO_2$, $InSnO_x$, $SiC_x$, $SiN_x$, $SiO_2$, $SiO_x$, $Al_2O_3$, MgO, $NiO_x$ and other transition metal oxides, alkali halides, alkali earth halides and the like. Medium band gap materials can be utilized such as amorphous Ge and amorphous Si:Ge alloys. If amorphous silicon containing hydrogen and/or fluorine is utilized for the semiconducting layers, then $As_2S_3$ and other amorphous semiconductors that provide electronegativity differences between the layers can be utilized for the alternating layers.

Another generic type of structure can be formed of alternating layers of semiconductors and metals, i.e., s-m-s-m . . . . This structure can provide another way of "doping" amorphous silicon. For example, layers of about 50Å of amorphous silicon-fluorine-hydrogen or silicon-hydrogen alloys may be interspersed with about 4Å layers of a dopant element, such as Al, Ga or In. Preparation of this structure is not possible in any single chamber or single gas injection deposition apparatus since the dopants can contaminate the single chamber.

The s-m-s-m . . . structures can also be formed of materials and layer pairs for use in X-ray dispersive structures. This combination system provides an enhanced flexibility in the types of material layers which can be formed for X-ray dispersion and reflection applications.

Another generic material can be thought of as an n-doped and p-doped structure, i.e., p-n-p-n . . . or p-i-n-i-p. In making these structures, the n-type and p-type layers can be totally and independently controlled, so that the best parameter p-type material layer can be alternated with the best parameter n-type material layer. The layered structures have an increased carrier drift/field effect mobility which results in very long excess carrier lifetimes and photocarrier lifetimes and hence enhanced lifetime photoconductivities. This result occurs because the internal electric fields between the n-type and p-type layers separate the photoexcited electrons and holes. The holes and electrons are thought to be separated and spatially trapped in the multiple layer structures and hence their recombination probability is greatly reduced. The band gap of these structures is an effective band gap determined by the alternating layer types, thicknesses, carrier concentrations, etc. The electronic and optical properties are tuned by varying these determining factors as desired.

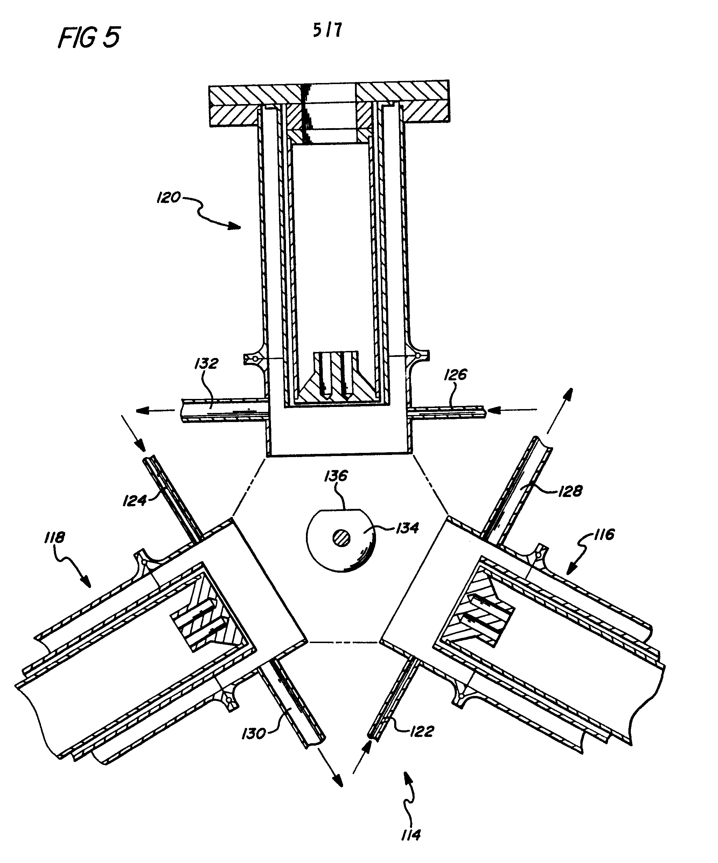

A further example of the flexibility of the apparatus and method of the invention and the structures produced thereby is best illustrated in Fig. 5 by a three chamber deposition apparatus 114. Apparatus 114 includes three deposition chambers 116, 118 and 120. The chambers are illustrated as being the same as chambers 12 and 14 of Figs. 1 and 2; however, each chamber can also be a different type of deposition system as previously described.

Each chamber 116, 118 and 120 includes at least one respective deposition gas inlet 122, 124 and 126 and at least one respective exhaust port 128, 130 and 132. A substrate holder 134 is illustrated without the surrounding seals and exhaust system, which would be similar to those of module 16, except that three deposition positions 136 are provided for one or more substrates. If the time unit is equalized for each deposition position, then there can be at least three separate positions 136. Preferably three substrates are mounted on holder 134 so that one layer of the multiple layer structure is deposited simultaneously at each position. Thus, apparatus 114 allows the simultaneous fabrication of
three or more multiple layer structure sets of the type A, B, and C. It
can also be used to produce a double layer of one type of material, if
desired, or permits two different types of deposition chambers to be used
to deposit the same material. Further, as above described, the gas
composition in each chamber can be altered or controlled, such as with
shutters and/or premixing, and/or a plurality of evaporation sources can
be utilized to form the structure.

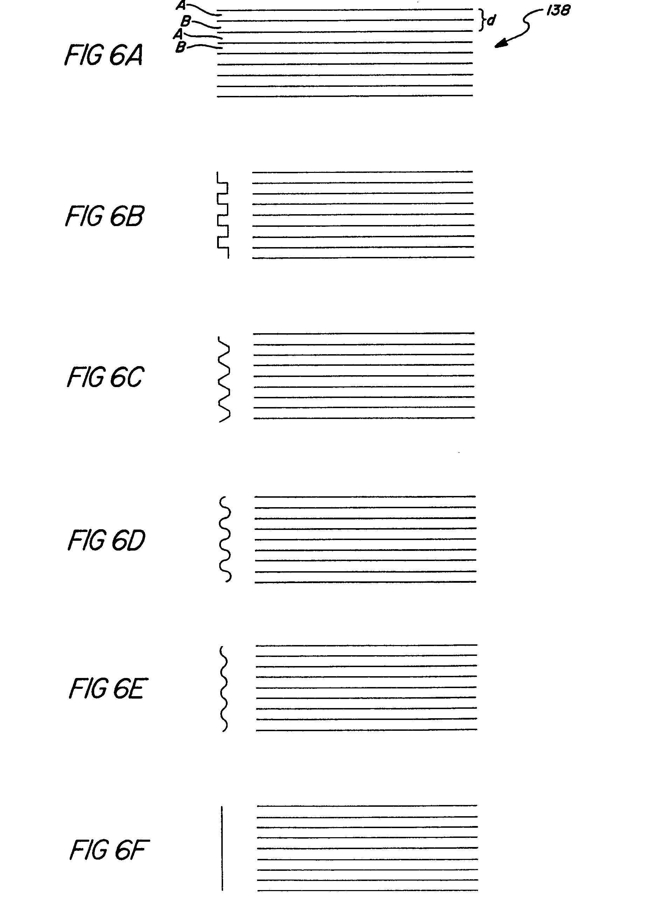

Referring now to Fig. 6A, a side sectional view of a multiple
layer semiconductor material 138 is illustrated. The structure includes
a plurality of layers 138a, 138b, 138c,... that may, for example, be
layer pairs A and B. Each set, or layer pair has a characteristic d
spacing or distance, which is the distance between layer sets. As
described above, A can be a semiconductor material of one conductivity
type and B can be a second semiconductor material of opposite
conductivity type, such that a p-n-p-n structure is formed. A structure
having an A, B and C set could be a p-i-n-p-i-n, etc. Also, A can be a
semiconductor and B a metal, a material having a different magnitude
and/or polarity of fixed charge, or a different conductivity type
material. The overall multiple layer structure can form one or more
portions of a semiconductor device as described below. The overall
multiple layer structure will have semiconducting properties which are
determined and adjusted by the types and thicknesses of the individual
layers in each layer set.

The effect of a sharp transition from one layer to the next is
illustrated by a schematic potential energy waveform in Fig. 6B.
Depending on the rates of gas decomposition or other material deposition
method in film growth, a more gradual potential energy distribution
transition can exist, an intermediate case of which is illustrated by
potential energy waveform in Fig. 6C. In this structure, the transition
from layer to layer occupies a finite fraction of the layer thickness. A
more extreme case is illustrated by potential energy waveform in Fig. 6D,
in which the layer-to-layer transition region extends over the entire
layer thickness, to form a structure having a continuously modulated
potential energy distribution. In each of the structures, the
periodicity of the overall structure can be determined from an x-ray diffraction measurement of the Bragg reflections of the structure. Still broader transition regions are possible as illustrated by the potential energy waveform in Fig. 6E. This very gradual layer-to-layer transition decreases the amplitude of the periodic potential energy variation. The extreme case is that of a material without layers which has no modulation of the potential energy distribution. Such a situation is illustrated by the straight line potential energy waveform in Fig. 6F.

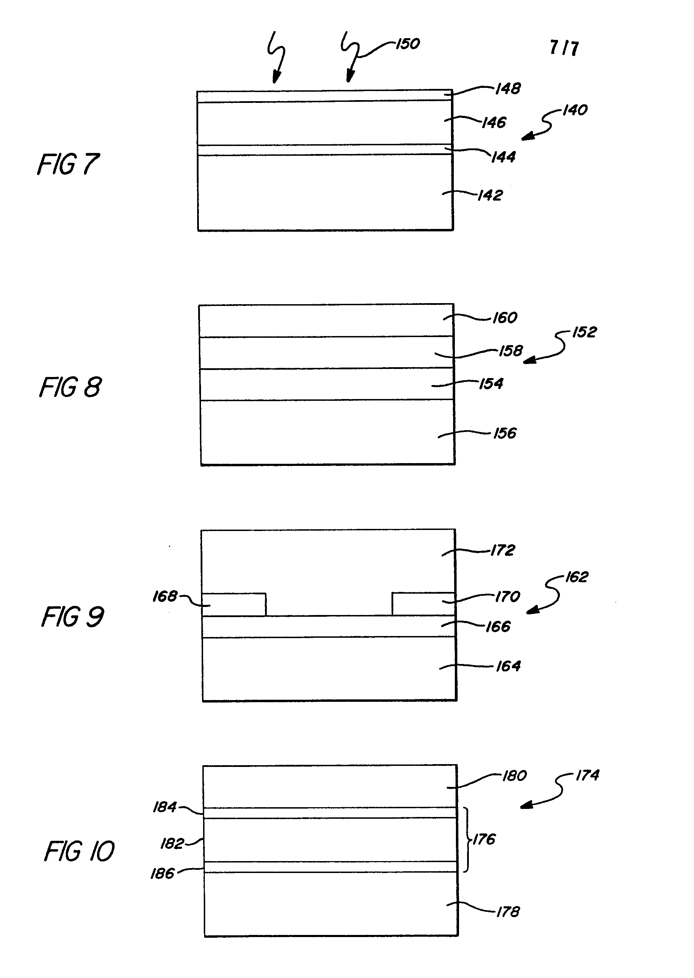

The semiconductor material structures of the invention can be utilized in any number of devices. Fig. 7 illustrates a p-i-n solar cell 140. The single cell 140 includes a substrate 142 onto which is formed an n-type section or region 144, an intrinsic region 146 and a p-type region 148. Regions 144, 146 and 148 are often called layers; however, to avoid confusion in terminology, in this description they are called sections or regions. Each of regions 144, 146 and 148 is generally a single type of material. But in a structure according to the invention, in which any one or more of regions 144, 146 and 148 may be multiple layer structures, each such region may contain on the order of a hundred or more layers. It follows that a single conductivity type portion or so-called layer in a p-i-n cell, such as cell 140, is very much thicker than any of the layers of the multiple layer structure of the invention.

As illustrated in Fig. 7, light 150 is directed into cell 140 through p-type region 148. Such a cell can be made from a plasma deposition system with a compensated silicon or germanium-based alloy having an n-type dopant in region 144, no dopant introduced into intrinsic region 146 and a p-type dopant in region 148. For single cell 140, a band gap of 1.5eV would be most desirable and would provide the most efficient conversion of sunlight impinging thereon.

In general, utilizing a silicon-based alloy containing fluorine and/or hydrogen, intrinsic region 146 has an effective band gap of 1.7 eV or above. The hydrogen and/or fluorine alloy constituents are density of states reducing elements that enhance the electronic properties of the alloy as is known in the art. Fluorine is especially useful as a density of states reducing element. Further, as mentioned above, diborane typically is utilized as the dopant in p region 148. Substitutional doping with diborane can sufficiently degrade the alloy in region 148 to effectively reduce the band gap in "window" region 148 below 1.7 eV.

Thus, cell 140 is not as efficient as it would be if the window region were not degraded. Optimally, region 148 should have a band gap of at least 1.8 eV and preferably about 2.0 eV.

The desired band gap structure can be achieved by utilizing the multiple layer structures of the invention in the embodiment of Fig. 7. The p-type region 148 is generally about 200A thick and in accordance with the invention, region 148 can be a multiple layer structure similar to Fig. 6A. Each of the layers of pairs A and B can be up to 30A thick to achieve an increased band gap. Layer A can be formed of a silicon-based alloy containing fluorine and/or hydrogen with the addition of methane ($CH_4$) and/or diborane ($B_2H_6$). Layer B may include the material of layer A plus ammonia ($NH_3$). This structure will effectively increase the band gap of the material and the Fermi level will be shifted toward the valence band, increasing conductivity. Alternately, an s-i-s-i structure can be utilized with proximity doping without introducing any impurity into the semiconducting layer A. In either example, the multiple layer structure can be formed in apparatus 10 by sequential rotation of substrate(s) 98 for alternate deposition in chambers 12 and 14 during deposition, or by gas injection during deposition in a single chamber.

Utilizing the structures of the invention, region 146 can be formed of a silicon and/or germanium-based alloy with fluorine and/or hydrogen, as layer A. Layer B can have the same elements and in addition, ammonia ($NH_3$) or silicon dioxide ($SiO_2$). This structural selection has several effects: it increases the band gap of region 146 and the band edges can be made sharper. These effects increase the band gap of a silicon-based alloy beyond 1.7 eV, but the sharper band edges (i.e. reduced band tails) provide a higher $V_{oc}$, so that no Staebler-Wronski (S-W) effect degrading of the device is observed and the photoconductivity is increased. Thus, a smaller amount of light is converted, but it is converted more efficiently. In the case of the germanium-based alloy, the band gap is generally of the order of 1.2 eV and adding the band gap altered layers can increase the band gap to the optimum 1.5 eV for the single cell embodiment 140.

A tandem cell device embodiment 152 is illustrated in Fig. 8, having a first cell 154 formed on a substrate 156. A second cell 158 is formed on first cell 154 and a third cell 160 can be formed on second cell 158, if desired. Each of the cells 154, 158 and 160 can be a p-i-n (or n-i-p) type cell similar to cell 140. At least one region of one of the cells may be formed from a multiple layer structure in accordance with the invention. The uppermost p-type region (or n-type if inverted) of tandem device 152 can be formed from a multiple layer structure in accordance with the invention to provide a light window for the cell. A silicon-based alloy cell 154 without the multiple layer structures of the invention will have a band gap of about 1.7 eV. The band gap of multiple layer cell 154 can be designed to be 1.4 to 1.5 eV. A second cell 158 can be formed from a silicon-based alloy cell without the multiple layer structures of the invention, which again can have a band gap of about 1.7 eV. This structure can provide an effective tandem cell device 152. A cell 158 which includes a silicon-based multiple layer structure can have a band gap of 1.9 to 2.1 eV, which with the other advantages above enumerated, will provide an enhanced efficiency tandem cell device. A third multiple layer silicon alloy-based cell 158 with a band gap of 1.9 to 2.1 eV can be added to form an enhanced three cell device. Cell 154 may alternatively include a germanium-based alloy multiple layer structure in accordance with the invention.

A silicon-germanium-based multiple layer alloy cell can also be utilized in device 152 to provide enhanced performance. In a silicon-based material, germanium or tin can be added to decrease the band gap of the resulting material and hence they can be called band gap decreasing elements. Carbon or nitrogen can be added to increase the band gap and hence they can be called band gap increasing elements. In general all of these elements can be called band gap adjusting elements. The adjusting elements can be released during deposition in very small amounts, and in substantially atomic layers. As a result, the chemistry and bonding of the adjusting elements in the structures are affected because of the large quantities of other layered materials surrounding the adjusting elements on an atomic scale.

The multiple layer structures of the invention also allow the valence and the conduction bands to be independently controlled. In a set of two repeating layers A and B, this control is provided by varying the nature and doping of layer B as described in reference to Fig. 6A.

If layer B is chosen to have a wider band gap than the band gap of semiconducting layer A and to be more p-type, then the conduction band edge of the multiple layer structure is increased more than the valence band edge is decreased. This effect can be utilized to convert an n-type semiconductor into a p-type semiconductor. Analogously, if layer B is more n-type than layer A, the valence band edge is decreased more than the conduction band edge is increased, which results in a more n-type multiple layered structure. This selection can control the effective band gaps of the structures. As above described, the conductivity type of the non-impurity doped semiconducting layers can be controlled by the adjacent layer type. This effect permits p-n and n-p-n type devices to be formed, such as rectifiers and bipolar type transistors. These p-n junction devices can include p-n thermoelectric devices which have enhanced efficiency, because the Peltier voltage is increased.

An improved type of thin film transistor (TFT) can also be formed, because of the sharper band edge possible in the multiple layer materials which can provide an enhanced carrier drift/field effect mobility, as above described. Also, the sharper band edges that are possible utilizing multiple layer structures mean that the silicon-insulator interface can be formed without being oxide/insulator limited. In one embodiment, $Si_3N_4$ can be graded to $SiN_x$ and then the multiple layer structure can be formed thereon. Source and drain electrodes are incorporated into the transistor, one embodiment 162 of which is illustrated in Fig. 9. Transistor 162 includes a metal, metallic or highly doped semiconductor region 164. An insulator region 166 is formed on region 164, which can be formed as above described. A source 168 and a drain 170 are formed on insulator 166. A semiconductor region 172 is then formed to complete the transistor 162. Each of the regions 164, 166, 168, 170 and 172 can include a multiple layer structure in accordance with the invention.

An improved photoreceptor 174 can also be formed utilizing the multiple layer structures of the invention as disclosed in Fig. 10. The resistance of the photoreceptor 174 varies with the amount of light impinging thereon. An alloy region 176 thereof has a band gap adjusted for the particular application for which photoreceptor 174 is to be utilized. Alloy region 176 is formed on a metallic substrate electrode and has a transparent top electrode 180 through which electromagnetic radiation can pass. Alloy region 176 prefereably includes an undoped substantially intrinsic region 182 and heavily doped regions 184 and 186. Doped regions 184 and 186 are of the same conductivity type and form low resistance ohmic contacts with electrodes 180 and 178, respectively. Each of regions 178, 180, 182, 184 and 186 can again be formed from the multiple layer structures of the invention. The dark conductivity is decreased because the activation energy is increased and the photoconductivity is enhanced as previously described, both effects combining to yield a greatly increased light-to-dark ratio.

As disclosed above, a material can be deposited in accordance with the invention by utilizing sets of layers of two materials A and B, of three materials A, B and C or of more than three materials. However, an atom or group of atoms, can also be inserted as desired within the various layers A and B to control parameters of the material. These groups of atoms can be formed from one type of atom or various types of atoms and can be compositionally different throughout the bulk. These atoms or groups of atoms can be inserted in a time sequence manner such as through one of port assemblies 64 or 66 of apparatus 10 and can include laser activation to modify local sites as the material is being deposited. Also, the multiple layer structures of materials can be much more complicated than that described above and can be, arranged for example in five layer material, A, B, C, B, C, D, C, E, etc., with regular or varying spacing between layers and between layer sets. Irregular spacing can be utilized to attain continuously variable disorder, an impossibility with a single material region even if amorphous, because of discrete atomic size and limited stereochemistry of the constituent atoms. One layer can utilize a material which can normally form layers in synthetic crystalline and natural crystalline form. As an example, graphite can be deposited between layers of silicon or silicon alloy.

The techniques of the invention can be utilized as a new way of doping amorphous photovoltaic materials or changing the band gap as desired within the photovoltaic material, controlling the phonon and electron relationships in a thermoelectric material to provide the desired thermal and electrical conductivity properties and in catalysis to provide the number and types of sites desired. The optical properties of such materials can be changed independently of changing the electronic properties. Unique anisotropic effects can be produced by the placement of atoms or groups of atoms in the matrix throughout a composite multiple layered material. The layers can be useful in modifying dielectric or optical absorption properties, in providing electrical isolation or for providing electrical connections. Additional layers can also be desirable for relieving strains in the multiple layer structures, to prevent diffusion of materials between layers or for reducing the interface states and defects at the layer boundaries.

As mentioned above, the two-chamber apparatus 10, illustrated in Figs. 1-4, can provide periodic or nonperiodic amorphous semiconducting multiple layer structures which contain more than two different layer materials. While the substrate 98 is in the chamber 12, the composition of the plasma feed gas or the sputtering gas in the line 60, or in a separate feed line, can be kept constant for the length of time necessary to deposit a desired layer thickness of material A. The composition of the gas then can be changed for a period of time to deposit a layer of material B onto the layer A. The layers can be graded if desired, by changing the feed gas mixture gradually. The gas composition can be changed to a third composition to deposit a layer of material C. The same or a different sequence of layer depositions can be performed in chamber 14. Also, evaporation, ion beam injection or sputtering can be utilized or combined with the plasma techniques and can be controlled, for example by shutters, if desired.

The invention is not limited to amorphous material layers. For example, when utilizing alkali halides or alkali earth halides, the layers generally will not be amorphous.

## CLAIMS

1. An improved semiconductor structure (138) having a multiple layer structure characterized by a plurality of layers (138a, 138b, ...) formed on one another, at least one of said layers (138a) being formed from a first layer material comprising a disordered semiconductor material, and at least a second layer (138b) being formed from a material selected from the group consisting of materials having a conductivity type, magnitude and/or polarity of fixed charge capability and/or band gap different from that of said first layer material.

2. An improved photoresponsive device (140) having superimposed sections (144, 146, 148) of various materials including at least one section having an active photoresponsive region (146) therein upon which radiation can impinge to produce charge carriers, characterized in that at least one of said sections (144, 146, 148) includes:

a multiple layer semiconductor structure including a plurality of layers formed on one another, at least one of said layers being formed from a first layer material comprising a disordered semiconductor material, and at least a second layer being formed from a material selected from the group consisting of materials having conductivity type, magnitude and/or polarity of fixed charge capability and/or band gap different from that of said first layer material.

3. The device of claim 2 further characterized in that said sections include at least one region of fixed conductivity type therein, said region being formed by said multiple layer structure.

4. The structure of claims 1 or 2 further characterized in that said first layer material includes silicon and at least one band gap reducing element.

5. The structure of claim 4 characterized in that said second layer includes silicon and at least one of nitrogen and oxygen.

6. The structure of claims 1 or 2 characterized in that said first layer material includes germanium and at least one band gap adjusting element.

7. The structure of claim 6 characterized in that said second layer includes silicon and at least one of nitrogen and oxygen.

8.    A method of depositing an improved semiconductor on a substrate, characterized in:

providing a substrate (98) mounted on substrate holding means (16);

providing at least a pair of mutually isolated deposition chamber means (12, 14);

movably coupling said substrate holding means (16) and said chamber means (12, 14) for selective disposition of said substrate (98) within each of said chamber means (12, 14);

moving said substrate holding means (16) and chamber means (12, 14) relative to one another to selectively dispose said substrate in selected ones of said chamber means; and

depositing at least one different type material layer on said substrate in at least one of said chamber means to form a plurality of layers of said different type materials on one another, at least one of said material layers being a disordered semiconductor material.

9.    The method of claim 8 characterized in depositing at least two different type material layers successively on one another in at least one of said chamber means (12).

10.    The method of claim 8 characterized in depositing said material layers in at least one of said chambers (12) by plasma decomposition of a feed gas mixture.

11.    The method of claim 10 characterized in depositing at least two different type material layers successively on one another in at least one of said chamber means (12) by changing said feed gas mixture.

12.    The method of claim 8 including rotatably mounting said substrate holding means (16) and rotating said substrate holding means (16) to dispose said substrate (98) in each of said chamber means (12, 14) alternatively.

13.    Apparatus for depositing an improved semiconductor, characterized by:

substrate holding means (16) for holding at least one substrate (98);

at least a pair of mutually isolated deposition chamber means (12, 14) for depositing materials on said substrate (98);

18

means for movably coupling said substrate holder (16) and said chamber means (12, 14) together for selective disposition on said substrate (98) within each of said chamber means (12, 14); and

means for moving said substrate holding means (16) to selectively dispose said substrate (98) in selected ones of said chamber means (12, 14).

14. The apparatus of claim 13 further characterized by means for depositing at least two different type material layers successively on one another in at least one of said chamber means (12).

15. The apparatus of claim 13 characterized by means for depositing said material layers in at least one of said chambers (12) by plasma decomposition of a feed gas mixture.

16. The apparatus of claim 15 characterized by means for depositing at least two different type material layers successively, on one another, in at least one of said chamber means (12) by changing said feed gas mixture.

17. The apparatus of claim 13 characterized in that means for moving said substrate holding means (16) include means for rotating said substrate holding means (16) to selectively dispose said substrate (98) in selected chamber means (12, 14).

FIG 1

FIG 2

FIG 3

FIG 4

82

16

108

100

96

70

74

76

72

110

102

88

86

90

4/7

0145403

FIG 5

5/7

0145403

0145403

6 / 7

FIG 6A

FIG 6B

FIG 6C

FIG 6D

FIG 6E

FIG 6F

0145403

7/7

FIG 7

FIG 8

FIG 9

FIG 10